# EUROPÄISCHE PATENTANMELDUNG

(11) **EP 4 443 487 A1**
(43) Veröffentlichungstag der Anmeldung: **09.10.2024**
(21) Anmeldenummer: 23166548.0
(22) Anmeldetag: 04.04.2023
(51) Int. Cl.: H01L 23/00

(54) **SUBSTRATANORDNUNG MIT OBERFLÄCHENSTRUKTUR**

(71) Anmelder: Heraeus Electronics GmbH & Co. KG, 63450 Hanau (DE)
(72) Erfinder: HINRICH, Andreas, 63450 Hanau (DE); KLEIN, Andreas Steffen, 63450 Hanau (DE); KRÜGER, Frank, 63450 Hanau (DE); STOICA, Stefanie, 63450 Hanau (DE)
(74) Vertreter: Heraeus IP

(57) **Zusammenfassung**

Die Erfindung betrifft eine Substratanordnung und ein Verfahren zur Herstellung einer elektronischen Baugruppe.

Die Substratanordnung weist auf (a) ein Bondsubstrat, das eine Oberseite und eine Unterseite umfasst, und (b) eine Kontaktierungsschicht, die ein Kontaktierungsmittel umfasst, wobei die Kontaktierungsschicht mit der Unterseite des Bondsubstrats wenigstens bereichsweise flächig verbunden ist, wobei die Unterseite des Bondsubstrats (i) einen arithmetischen Mittenrauwert R(1)ₐ entlang wenigstens einer Strecke S1 aufweist, und (ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft, wobei das Verhältnis Q von arithmetischem Mittenrauwert R(1)ₐ zu arithmetischem Mittenrauwert R(2)ₐ im Bereich von 1,70 - 10,00 liegt.

## Beschreibung

Die vorliegende Erfindung betrifft eine Substratanordnung und ein Verfahren zur Herstellung einer elektronischen Baugruppe.

Zur Herstellung von elektronischen Baugruppen werden in der Leistungselektronik häufig Grundsubstrate, insbesondere Metall-Keramik-Substrate oder Leadframes, mit Elektronikbauteilen, insbesondere Halbleitern, bestückt.

Auf der Oberseite der Elektronikbauteile, die den Grundsubstraten abgewandt ist, befinden sich Bereiche, die mit unbestückten Bereichen der Grundsubstrate elektrisch leitend kontaktiert werden müssen. Diese Kontaktierung erfolgt üblicherweise mit Bonddrähten, wobei ein Ende des Bonddrahts stoffschlüssig mit einem Bereich auf der Oberseite des Elektronikbauteils verbunden wird, während das andere Ende des Bonddrahts stoffschlüssig mit einem unbestückten Bereich des Grundsubstrats verbunden wird. Bonddrähte aus Aluminium können mit dem Metall der Grundsubstrate, insbesondere Kupfer, stoffschlüssig verbunden werden. Auch mit den Elektronikbauteilen lassen sich Bonddrähte aus Aluminium, zum Beispiel über eine metallische, zumeist silberhaltige Schicht, die sich auf der Oberseite der Elektronikbauteile befindet, stoffschlüssig verbinden. Bonddrähte aus Aluminium weisen allerdings den Nachteil einer geringen elektrischen Leitfähigkeit auf. Ferner hat sich herausgestellt, dass eine elektrische Kontaktierung von Elektronikbauteilen und Grundsubstraten über Bonddrähte aus Aluminium eine nur unzureichende Zuverlässigkeit und verminderte Funktionsfähigkeit aufweisen.

Aus diesem Grund gibt es den Bedarf, Bonddrähte aus Aluminium durch Bonddrähte aus Kupfer zu ersetzen. Kupfer weist im Vergleich zu Aluminium eine sehr hohe elektrische Leitfähigkeit auf. Darüber hinaus lassen sich Bonddrähte aus Kupfer mit dem Metall der Grundsubstrate, insbesondere Kupfer, besonders zuverlässig stoffschlüssig verbinden. Allerdings können Bonddrähte aus Kupfer nicht ohne weiteres stoffschlüssig mit der Oberseite der Elektronikbauteile verbunden werden.

Im Stand der Technik wird daher vorgeschlagen, Bonddrähte aus Kupfer nicht direkt mit der Oberseite der Elektronikbauteile zu verbinden. Vielmehr wird eine Substratanordnung bereitgestellt, die ein Bondsubstrat und eine Kontaktierungsschicht aufweist. Das Bondsubstrat, üblicherweise eine Metallfolie, weist eine Oberseite und eine Unterseite auf, wobei die Unterseite des Bondsubstrats mit der Kontaktierungsschicht, üblicherweise einer vorgetrockneten Sinterpaste, flächig verbunden ist. Das Bondsubstrat der Substratanordnung wird schließlich über die Kontaktierungsschicht mit der Oberseite des Elektronikbauteils stoffschlüssig verbunden, so dass die Oberseite des Bondsubstrats für eine stoffschlüssige Verbindung mit dem Kupferbonddraht zur Verfügung steht.

Eine zuverlässige Verbindung eines Bonddrahtes mit der Oberseite eines Elektronikbauteils über eine Substratanordnung setzt voraus, dass das Bondsubstrat mit der Oberseite des Elektronikbauteils über die Kontaktierungsschicht stabil stoffschlüssig verbunden werden kann.

Es besteht daher Bedarf an einer Substratanordnung, mit der das Bondsubstrat mit der Oberseite des Elektronikbauteils über die Kontaktierungsschicht besonders stabil stoffschlüssig verbunden werden kann.

Daher besteht eine Aufgabe der vorliegenden Erfindung vorzugsweise darin, eine Substratanordnung bereitzustellen, die eine stabile stoffschlüssige Verbindung zwischen dem Bondsubstrat und der Oberseite des Elektronikbauteils über die Kontaktierungsschicht ermöglicht.

Diese Aufgabe wird gelöst durch die Substratanordnung gemäß Anspruch 1.

Die Erfindung stellt daher eine Substratanordnung bereit, aufweisend
(a) ein Bondsubstrat, das eine Oberseite und eine Unterseite umfasst, und
(b) eine Kontaktierungsschicht, die ein Kontaktierungsmittel umfasst, wobei die Kontaktierungsschicht mit der Unterseite des Bondsubstrats wenigstens bereichsweise flächig verbunden ist,
wobei die Unterseite des Bondsubstrats
(i) einen arithmetischen Mittenrauwert R(1)ₐ entlang wenigstens einer Strecke S1 aufweist, und
(ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft,
wobei das Verhältnis Q von arithmetischem Mittenrauwert R(1)ₐ zu arithmetischem Mittenrauwert R(2)ₐ im Bereich von 1,70 - 10,00 liegt.

Ferner stellt die Erfindung ein Verfahren zur Herstellung einer elektronischen Baugruppe bereit.

Die Erfindung betrifft eine Substratanordnung.

Mit der Substratanordnung kann vorzugsweise die elektrische Kontaktierung der Oberseite eines Elektronikbauteils mit unbestückten Bereichen von Grundsubstraten vorbereitet werden. Hierzu wird das Bondsubstrat über die Kontaktierungsschicht mit der Oberseite des Elektronikbauteils stoffschlüssig verbunden. Das Bondsubstrat stellt dabei eine Oberfläche bereit, die für die Ausbildung einer zuverlässigen stoffschlüssigen Verbindung mit einem Ende eines Bonddrahtes, insbesondere eines Kupferbonddrahtes, geeignet ist. Das andere Ende des Bonddrahtes kann mit einem unbestückten Bereich eines Grundsubstrats verbunden werden, so dass eine elektrische Kontaktierung zwischen der Oberseite des Elektronikbauteils und einem unbestückten Bereich eines Grundsubstrats über das Bondsubstrat und den Bonddraht resultiert.

Die Substratanordnung weist ein Bondsubstrat auf.

Das Bondsubstrat umfasst eine Oberseite und eine Unterseite. Die Unterseite des Bondsubstrats ist vorzugsweise die Fläche des Bondsubstrats mit dem größten Flächeninhalt, die mit der Kontaktierungsschicht wenigstens bereichsweise flächig verbunden ist. Daher ist die Oberseite des Bondsubstrats vorzugsweise die der Kontaktierungsschicht abgewandte Seite des Bondsubstrats. Die Oberseite des Bondsubstrats ist folglich die der Unterseite des Bondsubstrats gegenüberliegende Seite. Das Bondsubstrat weist vorzugsweise eine Dicke im Bereich von 5 - 500 µm, besonders bevorzugt eine Dicke im Bereich von 10 - 450 µm und ganz besonders bevorzugt eine Dicke im Bereich von 20 - 400 µm auf.

Gemäß einer bevorzugten Ausführungsform umfasst das Bondsubstrat eine Metallfolie. Ganz besonders bevorzugt ist das Bondsubstrat eine Metallfolie.

Die Metallfolie umfasst vorzugsweise wenigstens ein Element, das aus der Gruppe ausgewählt ist, die aus Metallen und Metalllegierungen besteht. Gemäß einer weiteren bevorzugten Ausführungsform umfasst die Metallfolie wenigstens ein Element, das aus der Gruppe ausgewählt ist, die aus Kupfer und Kupferlegierungen besteht. Gemäß einer besonders bevorzugten Ausführungsform umfasst die Metallfolie Kupfer. Dabei kann es bevorzugt sein, dass Kupferlegierungen Legierungen von Kupfer mit wenigstens einem weiteren Metall sind, das aus der Gruppe ausgewählt ist, die aus Nickel, Zinn, Eisen, Silber, Wolfram und Molybdän besteht.

Gemäß einer bevorzugten Ausführungsform umfasst die Metallfolie einen Grundkörper. Unter Grundkörper wird hierin vorzugsweise eine beschichtungsfreie Metallfolie verstanden. Der Grundkörper umfasst vorzugsweise wenigstens ein Element, das aus der Gruppe ausgewählt ist, die aus Metallen und Metalllegierungen besteht. Gemäß einer weiteren bevorzugten Ausführungsform umfasst der Grundkörper wenigstens ein Element, das aus der Gruppe ausgewählt ist, die aus Kupfer und Kupferlegierungen besteht. Gemäß einer besonders bevorzugten Ausführungsform umfasst der Grundkörper Kupfer. Dabei kann es bevorzugt sein, dass Kupferlegierungen Legierungen von Kupfer mit wenigstens einem weiteren Metall sind, das aus der Gruppe ausgewählt ist, die aus Nickel, Zinn, Eisen, Silber, Wolfram und Molybdän besteht.

Gemäß einer besonders bevorzugten Ausführungsform ist die Metallfolie aus dem Grundkörper gebildet. Gemäß dieser Ausführungsform kann es demnach vorgesehen sein, dass es sich bei dem Bondsubstrat um eine unbeschichtete Kupferfolie handelt. Gemäß dieser besonders bevorzugten Ausführungsform wird die Unterseite des Bondsubstrats von der Metallfolie und die Oberseite des Bondsubstrats von der Metallfolie geschaffen. Dementsprechend wird die Unterseite des Bondsubstrats von dem Grundkörper und die Oberseite des Bondsubstrats von dem Grundkörper geschaffen.

Gemäß einer weiteren besonders bevorzugten Ausführungsform umfasst die Metallfolie einen Grundkörper und eine Beschichtung. Die Beschichtung ist dabei vorzugsweise auf dem Grundkörper angeordnet. Die Beschichtung umfasst vorzugsweise ein Edelmetall. Das Edelmetall ist vorzugsweise aus der Gruppe ausgewählt, die aus Gold, Silber und Palladium besteht. Vorzugsweise umfasst die Beschichtung wenigstens eine erste Lage aufweisend ein Edelmetall, wobei die erste Lage aufweisend das Edelmetall mit der Kontaktierungsschicht wenigstens bereichsweise flächig verbunden ist. Die erste Lage kann aus einem Edelmetall oder einer Edelmetalllegierung gebildet sein. Die Edelmetalllegierung ist vorzugsweise eine Legierung, die wenigstens ein Edelmetall und wenigstens ein Nichtedelmetall enthält. Das Nichtedelmetall der Edelmetalllegierung ist vorzugsweise Nickel. Die Edelmetalllegierung ist vorzugsweise aus der Gruppe ausgewählt, die aus Nickel-Gold-Legierungen, Nickel-SilberLegierungen und Nickel-Palladium-Gold-Legierungen besteht. Gemäß einer bevorzugten Ausführungsform umfasst die Beschichtung wenigstens eine weitere Lage. Die wenigstens eine weitere Lage ist vorzugsweise flächig mit der ersten Lage verbunden. Die wenigstens eine weitere Lage ist vorzugsweise nicht flächig mit der Kontaktierungsschicht verbunden. Gemäß einer bevorzugten Ausführungsform umfasst die wenigstens eine weitere Lage ein Edelmetall oder ein Nichtedelmetall. Das Nichtedelmetall ist vorzugsweise Nickel. Die wenigstens eine weitere Lage kann aus einem Edelmetall, einer Edelmetalllegierung oder einer Nichtedelmetalllegierung (einer Legierung, die kein Edelmetall umfasst) gebildet sein. Die Edelmetalllegierung ist vorzugsweise eine Legierung, die wenigstens ein Edelmetall und wenigstens ein Nichtedelmetall enthält. Gemäß einer besonders bevorzugten Ausführungsform umfasst die Beschichtung eine erste Lage aufweisend Gold, eine zweite Lage aufweisend Palladium und eine dritte Lage aufweisend Nickel, insbesondere eine erste Lage aus Gold, eine zweite Lage aus Palladium und eine dritte Lage aus Nickel. Dabei ist vorzugsweise die dritte Lage wenigstens bereichsweise flächig mit der Kontaktierungsschicht verbunden, die zweite Lage wenigstens bereichsweise flächig mit der dritten Lage und der ersten Lage verbunden und die erste Lage wenigstens bereichsweise flächig mit der zweiten Lage und dem Grundkörper verbunden. Gemäß einer ganz besonders bevorzugten Ausführungsform weist die erste Lage eine Dicke im Bereich von 10 - 150 nm, die zweite Lage eine Dicke im Bereich von 50 - 200 nm und die dritte Lage eine Dicke im Bereich von 1 - 5 µm auf. Die Beschichtung der Metallfolie erfolgt vorzugsweise durch Galvanisierung oder chemische Abscheidung. Gemäß dieser Ausführungsform wird die Unterseite des Bondsubstrats von der Beschichtung geschaffen. Dabei wird vorzugsweise die Unterseite des Bondsubstrats von der Beschichtung und die Oberseite des Bondsubstrats vom Grundkörper geschaffen.

Folglich umfasst das Bondsubstrat vorzugsweise eine Metallfolie, die einen Grundkörper umfasst, auf dem eine Beschichtung angeordnet sein kann, wobei die Unterseite des Bondsubstrats (i) durch den Grundkörper geschaffen ist, wenn auf dem Grundkörper keine Beschichtung angeordnet ist, und (ii) durch die Beschichtung geschaffen ist, wenn auf dem Grundkörper eine Beschichtung angeordnet ist.

Gemäß einer weiteren bevorzugten Ausführungsform weist das Bondsubstrat wenigstens eine Durchgangsöffnung von der Oberseite zur Unterseite auf. Unter Durchgangsöffnung ist vorzugsweise eine Ausnehmung im Material des Bondsubstrats zu verstehen, die sich von einer ersten Öffnung auf der Oberseite des Bondsubstrats bis zu einer zweiten Öffnung auf der Unterseite des Bondsubstrats erstreckt. Die Öffnungen können dabei unterschiedliche Größen und Geometrien aufweisen. Es kann bevorzugt sein, dass das Bondsubstrat mehrere Durchgangsöffnungen aufweist. Die Durchgangsöffnungen können beispielsweise zylindrisch, rund, rechteckig, oval, elliptisch oder rechteckig mit abgerundeten Ecken ausgestaltet sein. Die Gegenwart von Durchgangsöffnungen kann insbesondere dann vorteilhaft sein, wenn die Substratanordnung eine Vorfixierschicht umfasst, die ein Vorfixiermittel enthält. In diesem Fall können sich Anteile oder Reste des Vorfixiermittels bei einer Temperaturbeaufschlagung oder Druckbeaufschlagung, wie zum Beispiel bei einem Sintervorgang, verflüssigen und in die Durchgangsöffnungen aufgrund der durch die Durchgangsöffnung hervorgerufenen Kapillarwirkung aufgenommen werden, um dadurch ein unkontrollierbares Austreten der Anteile oder Reste des Vorfixiermittels zu vermeiden.

Die Substratanordnung weist eine Kontaktierungsschicht auf.

Die Kontaktierungsschicht ist eine Schicht, die mit der Unterseite des Bondsubstrats wenigstens bereichsweise flächig verbunden ist.

Gemäß einer bevorzugten Ausführungsform ist die Kontaktierungsschicht mit der Unterseite des Bondsubstrats flächig so verbunden, dass wenigstens 75%, mehr bevorzugt wenigstens 90%, besonders bevorzugt wenigstens 95%, ganz besonders bevorzugt wenigstens 98% und insbesondere 100%, der von der Unterseite des Bondsubstrats eingenommenen Fläche mit Kontaktierungsschicht versehen ist.

Die Kontaktierungsschicht weist vorzugsweise eine Schichtdicke im Bereich von 5 - 500 µm, besonders bevorzugt eine Schichtdicke im Bereich von 5 - 100 µm und ganz besonders bevorzugt eine Schichtdicke im Bereich von 10 - 50 µm auf.

Die Kontaktierungsschicht umfasst ein Kontaktierungsmittel. Das Kontaktierungsmittel ist vorzugsweise in der Lage, mit einem Elektronikbauteil, insbesondere der gegebenenfalls metallisierten Oberseite eines Elektronikbauteils, eine stoffschlüssige Verbindung einzugehen. Gemäß einer bevorzugten Ausführungsform umfasst das Kontaktierungsmittel wenigstens ein Element, das aus der Gruppe ausgewählt ist, die aus Sintermaterialien, Lotmaterialien und Klebstoffen besteht.

Das Sintermaterial ist vorzugsweise aus der Gruppe ausgewählt, die aus Sinterpasten, Sinterfolien und Sintervorformen besteht. Das Sintermaterial umfasst vorzugsweise wenigstens ein Element, das aus der Gruppe ausgewählt ist, die aus Silber und Kupfer besteht. Gemäß einer besonders bevorzugten Ausführungsform umfasst das Sintermaterial Silber.

Gemäß einer bevorzugten Ausführungsform umfasst das Sintermaterial eine Sinterpaste. Bei der Sinterpaste handelt es sich vorzugsweise um eine fachübliche Sinterpaste. Vorzugsweise umfasst die Sinterpaste wenigstens ein Element, das aus der Gruppe ausgewählt ist, die aus Silber und Kupfer besteht, und eine organische Verbindung. Es kann bevorzugt sein, dass das wenigstens eine Element, das aus der Gruppe ausgewählt ist, die aus Silber und Kupfer besteht, besonders bevorzugt Silber, in der Sinterpaste in Form von Partikeln vorliegt. Die Partikel können eine beliebige Form annehmen und daher beispielsweise als sphärische Partikel, Flakes oder unregelmäßig geformte Partikel vorliegen. Die organische Verbindung ist vorzugsweise aus der Gruppe ausgewählt, die aus Dispersionsmitteln, Bindemitteln, Fettsäuren und Mischungen davon besteht. Die Dispersionsmittel können aus fachüblichen Dispersionsmitteln ausgewählt sein. Ein beispielhaftes Dispersionsmittel ist Terpineol. Die Bindemittel können aus fachüblichen Polymeren ausgewählt sein. Beispielhaft genannt seien Zellulosederivate, so zum Beispiel Methylzellulose, Ethylzellulose, Ethylmethylzellulose, Carboxyzellullose und Hydroxypropylzellullose. Die Fettsäuren können aus fachüblichen Fettsäuren ausgewählt sein. Vorzugsweise sind die Fettsäuren aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure) und Lignocerinsäure (Tetracosansäure) besteht. Vorzugsweise ist die Sinterpaste vorgetrocknet. Die Vortrocknung kann dazu dienen, in der Sinterpaste enthaltenen flüchtigen Bestandteile, wie zum Beispiel organische Verbindung, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen.

Gemäß einer weiteren bevorzugten Ausführungsform umfasst das Sintermaterial eine Sinterfolie. Vorzugsweise handelt es sich bei der Sinterfolie um eine fachübliche Sinterfolie, wie sie zum Beispiel in der europäischen Patentanmeldung EP3154729 A1 offenbart ist. Eine Sinterfolie kann daher zum Beispiel eine Sinterpaste, die Metallpartikel (insbesondere Silberpartikel) und ein Bindemittel umfasst, aufweisen, die auf einem Trägersubstrat vorgetrocknet vorliegt. Die Sinterfolie kann zum Beispiel eine Dicke im Bereich von 5 - 300 µm aufweisen.

Gemäß einer weiteren bevorzugten Ausführungsform umfasst das Sintermaterial eine Sintervorform. Vorzugsweise handelt es sich bei der Sintervorform um eine fachübliche Sintervorform, wie sie zum Beispiel in der europäischen Patentanmeldung EP2428293 A2 offenbart ist.

Gemäß einer weiteren bevorzugten Ausführungsform umfasst das Lotmaterial eine Lotpaste. Bei der Lotpaste handelt es sich vorzugsweise um eine fachübliche Lotpaste. Die Lotpaste umfasst vorzugsweise eine Lotlegierung und ein Flussmittel. Die Lotlegierung umfasst vorzugsweise als Hauptelement (Element mit dem größten Gewichtsanteil) Zinn, besonders bevorzugt wenigstens ein weiteres Element, das aus der Gruppe ausgewählt ist, die aus Kupfer und Silber besteht, und ganz besonders bevorzugt wenigstens ein weiteres Element, das aus der Gruppe ausgewählt ist, die aus Bismut, Antimon, Indium, Germanium, Cobalt, Eisen und Nickel besteht. Das Flussmittel ist vorzugsweise ein fachübliches Flussmittel, besonders bevorzugt ein organisches Flussmittel.

Gemäß einer weiteren bevorzugten Ausführungsform umfasst der Klebstoff einen Leitkleber. Beim Leitkleber handelt es sich vorzugsweise um einen fachüblichen Leitkleber. Der Leitkleber umfasst vorzugsweise Silberpartikel und ein Epoxidharz, das besonders bevorzugt bei einer Temperatur im Bereich von 120°C - 200°C aushärtet.

Gemäß einer bevorzugten Ausführungsform umfasst die Substratanordnung eine Vorfixierschicht.

Die Vorfixierschicht ist vorzugsweise eine Schicht, die mit wenigstens einer weiteren Seite verbunden ist. Bei der Vorfixierschicht kann es sich zum Beispiel um eine zusammenhängende Schicht oder um eine unterbrochene Schicht handeln. Die Dimension der zusammenhängenden Schicht ist nicht weiter eingeschränkt. Daher umfasst die zusammenhängende Schicht auch eine punktförmige Schicht. Im Fall einer zusammenhängenden Schicht kann die Vorfixierschicht mit der wenigstens einen weiteren Seite flächig verbunden sein. Im Fall einer unterbrochenen Schicht kann die Vorfixierschicht mehrere nicht miteinander in Kontakt stehende Abschnitte umfassen, die mit der wenigstens einen weiteren Seite flächig verbunden sind. Bei der wenigstens einen weiteren Seite handelt es sich vorzugsweise um eine Seite der Kontaktierungsschicht oder um eine Seite des Bondsubstrats. Gemäß einer bevorzugten Ausführungsform ist die Vorfixierschicht eine Schicht, die (i) mit der Unterseite des Bondsubstrats, (ii) mit der dem Bondsubstrat abgewandten Seite der Kontaktierungsschicht oder (iii) mit der Unterseite des Bondsubstrats und der dem Bondsubstrat abgewandten Seite der Kontaktierungsschicht verbunden ist. Sofern die Vorfixierschicht mit der Unterseite des Bondsubstrats verbunden ist, ist die Kontaktierungsschicht mit der Unterseite des Bondsubstrats vorzugsweise bereichsweise flächig verbunden und die Vorfixierschicht ist mit Bereichen der Unterseite des Bondsubstrats verbunden, die nicht flächig mit der Kontaktierungsschicht verbunden sind. Dabei sind die Kontaktierungsschicht und die Vorfixierschicht jeweils mit der Unterseite des Bondsubstrats verbunden und vorzugsweise nebeneinander angeordnet.

Gemäß einer bevorzugten Ausführungsform ist die Vorfixierschicht als zusammenhängende Schicht ausgebildet und mit der dem Bondsubstrat abgewandten Seite der Kontaktierungsschicht flächig verbunden, so dass wenigstens 20%, mehr bevorzugt wenigstens 50%, besonders bevorzugt wenigstens 70%, ganz besonders bevorzugt wenigstens 98% und insbesondere 100%, der Fläche der dem Bondsubstrat abgewandten Seite der Kontaktierungsschicht mit der Vorfixierschicht in Kontakt stehen.

Gemäß einer weiteren bevorzugten Ausführungsform ist die Vorfixierschicht als zusammenhängende Schicht punktförmig ausgebildet und steht mit der dem Bondsubstrat abgewandten Seite der Kontaktierungsschicht und/oder mit der Unterseite des Bondsubstrats in Kontakt.

Gemäß einer weiteren bevorzugten Ausführungsform ist die Vorfixierschicht als unterbrochene Schicht umfassend mehrere nicht miteinander in Kontakt stehende Abschnitte ausgebildet, die mit der dem Bondsubstrat abgewandten Seite der Kontaktierungsschicht und/oder mit der Unterseite des Bondsubstrats in Kontakt stehen.

Die Vorfixierschicht umfasst vorzugsweise ein Vorfixiermittel. Das Vorfixiermittel kann zu einer Vorfixierung der Substratanordnung an einem Elektronikbauteil dienen, damit der Aufbau umfassend die Substratanordnung und das Elektronikbauteil eine verbesserte Transportfähigkeit - zum Beispiel zum Ort der Weiterverarbeitung - aufweist. Vorzugsweise ist das Vorfixiermittel ein temporäres oder lösbares Fixiermittel, das zumindest eine vorübergehende Fixierung der Substratanordnung mit einem Elektronikbauteil ermöglicht. Geeignete Vorfixiermittel sind zum Beispiel in der europäischen Patentanmeldung EP3940758 A2 beschrieben.

Das Vorfixiermittel umfasst daher vorzugsweise wenigstens eine Verbindung, die aus der Gruppe ausgewählt ist, die aus thermoplastischen Polymeren, anorganischen Füllstoffpartikeln und organischen Lösungsmitteln besteht. Gemäß einer bevorzugten Ausführungsform umfasst das Vorfixiermittel wenigstens ein thermoplastisches Polymer und besonders bevorzugt wenigstens eine Verbindung, die aus der Gruppe ausgewählt ist, die aus anorganischen Füllstoffpartikeln und organischen Lösungsmitteln besteht.

Die thermoplastischen Polymere weisen vorzugsweise eine Glasübergangstemperatur im Bereich von 60 - 120 °C auf. Die Bestimmung der Glasübergangstemperatur wird vorzugsweise mittels Dynamischer Differenzkalorimetrie (DKK) oder mittels Differential Scanning Calorimetry (DSC) bei einer Aufheizrate von 10 °C/Minute durchgeführt. Bei den thermoplastischen Polymeren kann es sich insbesondere um (Meth)acrylcopolymere handeln. Die (Meth)acrylcopolymere weisen vorzugsweise eine Molmasse im Bereich von 35.000 - 70.000 g/mol auf (Mw = 35.000 bis 70.000 g/mol). Die Molmasse wird vorzugsweise mittels Gelpermeationschromatographie (GPC) bestimmt. Für die Gelpermeationschromatographie gilt: Polystyrolgel als stationäre Phase, Tetrahydrofuran als mobile Phase, Polystyrolstandards.

Die anorganischen Füllstoffpartikel sind vorzugsweise Partikel umfassend wenigstens ein Element, das aus der Gruppe ausgewählt ist, die aus Aluminiumoxid, Siliziumdioxid, Titandioxid, Zirkonsilikat, Calciumsilikat, Glimmer, Kaolin und α-Bornitrid besteht. Vorzugsweise weisen die anorganischen Füllstoffpartikel eine durchschnittliche Teilchengröße (d50) im Bereich von 5 - 20 µm und besonders bevorzugt im Bereich von 5 - 10 µm auf. Die Bestimmung der durchschnittlichen Teilchengröße (d50) erfolgt vorzugsweise mittels eines Laserbeugungsverfahrens.

Die organischen Lösungsmittel weisen vorzugsweise einen Siedepunkt von nicht mehr als 285°C auf. Gemäß einer bevorzugten Ausführungsform sind die organischen Lösungsmittel aus der Gruppe ausgewählt, die aus Aromaten, Ketonen, Estern, Glykolethern und Alkoholen besteht. Gemäß einer besonders bevorzugten Ausführungsform sind die organischen Lösungsmittel aus der Gruppe ausgewählt, die aus Toluol, Xylol, Methylethylketon, Methylisobutylketon, Ethylacetat, Isobutylacetat, Bernsteinsäuredimethylester, Diethylenglykolmonobutylether, Benzylalkohol und Terpineolen besteht. Gemäß einer ganz besonders bevorzugten Ausführungsform sind die organischen Lösungsmittel aus der Gruppe der Terpineole ausgewählt.

Die Unterseite des Bondsubstrats weist auf
(i) einen arithmetischen Mittenrauwert R(1)ₐ entlang wenigstens einer Strecke S1 und
(ii) einen arithmetischen Mittenrauwert R(2)ₐ entlang wenigstens einer Strecke S2, wobei die wenigstens eine Strecke S2 senkrecht zur wenigstens einen Strecke S1 verläuft,
wobei das Verhältnis Q von arithmetischem Mittenrauwert R(1)ₐ zu arithmetischem Mittenrauwert R(2)ₐ im Bereich von 1,70 - 10,00 liegt.

Der Mittenrauwert ist eine Messgröße der Rauheit einer Oberfläche; er wird an einer Strecke bestimmt. Rₐ steht für den arithmetischen Mittenrauwert gemäß der Norm DIN EN ISO 4287. Dabei beschreiben der Mittenrauwert R(1)ₐ das arithmetische Mittel der absoluten Höhenwerte entlang wenigstens einer Strecke S1 und der Mittenrauwert R(2)ₐ das arithmetische Mittel der absoluten Höhenwerte entlang wenigstens einer Strecke S2, wobei die wenigstens eine Strecke S2 senkrecht zur wenigstens einen Strecke S1 verläuft. Die Bestimmung des Mittenrauwerts R(1)ₐ und des Mittenrauwerts R(2)ₐ erfolgt demgemäß vorzugsweise gemäß der zum Anmeldetag gültigen Version der DIN EN ISO 4287.

Die Unterseite des Bondsubstrats weist einen arithmetischen Mittenrauwert R(1)ₐ entlang wenigstens einer Strecke S1 auf.

Der arithmetische Mittenrauwert R(1)ₐ wird entlang wenigstens einer Strecke S1 bestimmt. Vorzugsweise wird der arithmetische Mittenrauwert R(1)ₐ entlang einer Mehrzahl an Strecken S1 bestimmt. Besonders bevorzugt wird der arithmetische Mittenrauwert R(1)ₐ entlang einer Mehrzahl an Strecken S1 bestimmt, die parallel zueinander verlaufen. Ganz besonders bevorzugt wird der arithmetische Mittenrauwert R(1)ₐ entlang von wenigstens zehn Strecken S1 bestimmt, die parallel zueinander verlaufen. Die wenigstens eine Strecke S1 weist vorzugsweise eine Länge von wenigstens 20% und besonders bevorzugt eine Länge von wenigstens 25% des Umfangs des Bondsubstrats auf. Vorzugsweise weist das Bondsubstrat zwei gegenüberliegende, parallel zueinander verlaufende Ränder Rd1a und Rd1b auf, die durch die Strecke S(Rd)1 beabstandet sind, wobei die Länge der wenigstens einen Strecke S1 wenigstens 50% der Länge der Strecke S(Rd)1, mehr bevorzugt wenigstens 75% der Länge der Strecke S(Rd)1, besonders bevorzugt wenigstens 90% der Länge der Strecke S(Rd)1, ganz besonders wenigstens 95% der Länge der Strecke S(Rd)1 und insbesondere die gesamte Länge der Strecke S(Rd)1 umfasst. Für den Fall, dass der arithmetische Mittenrauwert R(1)ₐ entlang einer Mehrzahl an Strecken S1 bestimmt wird, beziehen sich die Angaben zur Länge der wenigstens einen Strecke S1 vorzugsweise auf die Durchschnittslänge.

Die Unterseite des Bondsubstrats weist einen arithmetischen Mittenrauwert R(2)ₐ entlang wenigstens einer Strecke S2 auf, wobei die wenigstens eine Strecke S2 senkrecht zur wenigstens einen Strecke S1 verläuft.

Der arithmetische Mittenrauwert R(2)ₐ wird entlang wenigstens einer Strecke S2 bestimmt. Vorzugsweise wird der arithmetische Mittenrauwert R(2)ₐ entlang einer Mehrzahl an Strecken S2 bestimmt. Besonders bevorzugt wird der arithmetische Mittenrauwert R(2)ₐ entlang einer Mehrzahl an Strecken S2 bestimmt, die parallel zueinander verlaufen. Ganz besonders bevorzugt wird der arithmetische Mittenrauwert R(2)ₐ entlang von wenigstens zehn Strecken S2 bestimmt, die parallel zueinander verlaufen. Die wenigstens eine Strecke S2 verläuft senkrecht zur wenigstens einen Strecke S1. Die wenigstens eine Strecke S2 weist vorzugsweise eine Länge von wenigstens 50%, besonders bevorzugt eine Länge von wenigstens 60% und ganz besonders bevorzugt eine Länge von wenigstens 70% der Länge der wenigstens einen Strecke S1 auf. Für den Fall, dass die arithmetischen Mittenrauwerte R(1)ₐ und R(2)ₐ entlang einer Mehrzahl an Strecken S1 und S2 bestimmt werden, weisen die Strecken S2 eine Durchschnittslänge von wenigstens 50%, besonders bevorzugt von wenigstens 60% und ganz besonders bevorzugt von wenigstens 70% der Durchschnittslänge der Strecken S1 auf. Vorzugsweise weist das Bondsubstrat zwei gegenüberliegende, parallel zueinander verlaufende Ränder Rd2a und Rd2b auf, die durch die Strecke S(Rd)2 beabstandet sind, wobei die Strecke S(Rd)2 senkrecht zur Strecke S(Rd)1 verläuft. Dabei umfasst die Länge der wenigstens einen Strecke S2 vorzugsweise wenigstens 50% der Länge der Strecke S(Rd)2, mehr bevorzugt wenigstens 75% der Länge der Strecke S(Rd)2, besonders bevorzugt wenigstens 90% der Länge der Strecke S(Rd)2, ganz besonders wenigstens 95% der Länge der Strecke S(Rd)2 und insbesondere die gesamte Länge der Strecke S(Rd)2. Für den Fall, dass der arithmetische Mittenrauwert R(2)ₐ entlang einer Mehrzahl an Strecken S2 bestimmt wird, beziehen sich die Angaben zur Länge der wenigstens einen Strecke S2 vorzugsweise auf die Durchschnittslänge.

Das Verhältnis Q von arithmetischem Mittenrauwert R(1)ₐ zu arithmetischem Mittenrauwert R(2)ₐ liegt im Bereich von 1,70 - 10,00.

Vorzugsweise liegt das Verhältnis Q von arithmetischem Mittenrauwert R(1)ₐ zu arithmetischem Mittenrauwert R(2)ₐ im Bereich von 1,70 - 8,00 und besonders bevorzugt im Bereich von 2,00 - 8,00.

Überraschenderweise wurde festgestellt, dass eine Substratanordnung, die ein Bondsubstrat aufweist, das so beschaffen ist, dass die Unterseite des Bondsubstrats (i) einen arithmetischen Mittenrauwert R(1)ₐ entlang wenigstens einer Strecke S1 aufweist, und (ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft, wobei das Verhältnis Q von arithmetischem Mittenrauwert R(1)ₐ zu arithmetischem Mittenrauwert R(2)ₐ im Bereich von 1,70 - 10,00 liegt, eine besonders stabile stoffschlüssige Verbindung zwischen dem Bondsubstrat und der Oberseite des Elektronikbauteils über die Kontaktierungsschicht ermöglicht.

Gemäß einer bevorzugten Ausführungsform umfasst die Unterseite des Bondsubstrats ein Profil mit sich wiederholenden Struktureinheiten entlang einer ersten Richtung, wobei sich die wenigstens eine Strecke S1 in die erste Richtung erstreckt.

Das Profil mit sich wiederholenden Struktureinheiten ergibt sich vorzugsweise dadurch, dass in die Unterseite des Bondsubstrats Vertiefungen eingebracht werden. Bei den sich wiederholenden Struktureinheiten kann es sich demnach zum Beispiel um eine Abfolge von Vertiefungen handeln. Das Einbringen von Vertiefungen erfolgt dabei vorzugsweise gerichtet. Dabei weist die Unterseite des Bondsubstrats entlang der wenigstens einen Strecke S1 vorzugsweise einen arithmetischen Mittenrauwert R(1)ₐ auf, der sich von dem arithmetischen Mittenrauwert R(2)ₐ entlang wenigstens einer Strecke S2, die senkrecht zur wenigstens einen Strecke S1 verläuft, unterscheidet.

Vorzugsweise erfolgt das Einbringen von Vertiefungen dadurch, dass die Unterseite des Bondsubstrats gewalzt wird. Dabei wird eine Walze über die Oberseite des Bondsubstrats entlang einer Walzrichtung geführt. Folglich umfasst die Unterseite des Bondsubstrats vorzugsweise ein Walzprofil entlang einer Walzrichtung, wobei sich die wenigstens eine Strecke S2 in Walzrichtung erstreckt.

Gemäß einer bevorzugten Ausführungsform ist die Substratanordnung zur Verbindung mit wenigstens einem Elektronikbauteil geeignet. Gemäß einer besonders bevorzugten Ausführungsform ist die Substratanordnung zur Verbindung des Bondsubstrats mit wenigstens einem Elektronikbauteil geeignet.

Unter Elektronikbauteil wird vorzugsweise ein elektronisches oder elektrisches Bauelement verstanden. Das Elektronikbauteil ist vorzugsweise aus der Gruppe ausgewählt, die aus Halbleiterkomponenten besteht. Die Halbleiterkomponenten sind vorzugsweise aus der Gruppe ausgewählt, die aus Transistoren, Dioden und integrierten Schaltkreisen besteht.

Gemäß einer bevorzugten Ausführungsform umfasst das Elektronikbauteil eine metallische Oberseitenbeschichtung. Die metallische Oberseitenbeschichtung kann dazu dienen, eine leichtere Anbindung des Bondsubstrats über die Kontaktierungsschicht an die Oberseite des Elektronikbauteils zu ermöglichen. Daher kann es bevorzugt sein, dass die Oberseite des Elektronikbauteils von der metallischen Oberseitenbeschichtung geschaffen wird. Vorzugsweise umfasst die metallische Oberseitenbeschichtung des Elektronikbauteils Silber. Gemäß einer bevorzugten Ausführungsform umfasst das Elektronikbauteil eine metallische Unterseitenbeschichtung. Die metallische Unterseitenbeschichtung kann dazu dienen, eine leichtere Anbindung des Grundsubstrats an die Unterseite des Elektronikbauteils zu ermöglichen. Daher kann es bevorzugt sein, dass die Unterseite des Elektronikbauteils von der metallischen Unterseitenbeschichtung geschaffen wird. Vorzugsweise umfasst die metallische Unterseitenbeschichtung des Elektronikbauteils wenigstens ein Edelmetall. Gemäß einer bevorzugten Ausführungsform umfasst die metallische Unterseitenbeschichtung des Elektronikbauteils wenigstens ein Element, das aus der Gruppe ausgewählt ist, die aus Silber, Aluminium, Titan und Nickel besteht, und ganz besonders bevorzugt Silber.

Mit der Substratanordnung kann vorzugsweise die elektrische Kontaktierung der Oberseite des Elektronikbauteils mit unbestückten Bereichen von Grundsubstraten vorbereitet werden. Hierzu wird das Bondsubstrat über die Kontaktierungsschicht mit der Oberseite des Elektronikbauteils stoffschlüssig verbunden. Das Bondsubstrat stellt dabei eine Oberfläche bereit, die für die stoffschlüssige Verbindung mit einem Bonddraht, insbesondere einem Kupferbonddraht, auf besonders stabile Weise geeignet ist.

Das Verfahren zur Herstellung der erfindungsgemäßen Substratanordnung ist nicht weiter eingeschränkt.

Gemäß einer bevorzugten Ausführungsform umfasst das Verfahren zur Herstellung der erfindungsgemäßen Substratanordnung die Schritte:
(A) Bereitstellung einer Metallfolie,
(B) Behandlung der Metallfolie unter Erhalt eines Bondsubstrats, das eine Oberseite und eine Unterseite umfasst, wobei die Unterseite des Bondsubstrats
   (i) einen arithmetischen Mittenrauwert R(1)ₐ entlang wenigstens einer Strecke S1 aufweist, und
   (ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft,
   wobei das Verhältnis Q von arithmetischem Mittenrauwert R(1)ₐ zu arithmetischem Mittenrauwert R(2)ₐ im Bereich von 1,70 - 10,00 liegt,
(C) Bereitstellung eines Kontaktierungsmittels und
(D) Aufbringen des Kontaktierungsmittels auf die Unterseite des Bondsubstrats unter Ausbildung einer Kontaktierungsschicht, wobei die Kontaktierungsschicht mit der Unterseite des Bondsubstrats wenigstens bereichsweise flächig verbunden ist.

In Schritt (A) des Verfahrens wird eine Metallfolie bereitgestellt.

Bei der Metallfolie handelt es sich vorzugsweise um eine wie hierin an anderer Stelle beschriebene Metallfolie. Die Metallfolie kann eine Beschichtung umfassen. Die Metallfolie kann andererseits auch beschichtungsfrei sein.

In Schritt (B) des Verfahrens wird die Metallfolie behandelt, wobei ein Bondsubstrat erhalten wird, das eine Oberseite und eine Unterseite umfasst, wobei die Unterseite des Bondsubstrats (i) einen arithmetischen Mittenrauwert R(1)ₐ entlang wenigstens einer Strecke S1 aufweist, und (ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft, wobei das Verhältnis Q von arithmetischem Mittenrauwert R(1)ₐ zu arithmetischem Mittenrauwert R(2)ₐ im Bereich von 1,70 - 10,00 liegt.

Je nach Ausgestaltung des Bondsubstrats kann in den Schritten (A) und (B) unterschiedlich vorgegangen werden.

Für den Fall, dass das Bondsubstrat eine Metallfolie umfassen soll, die einen Grundkörper und keine Beschichtung umfasst, kann gemäß einer ersten Ausführungsform in Schritt (A) eine Metallfolie bereitgestellt werden, die keine Beschichtung aufweist, und in Schritt (B) die Metallfolie so behandelt werden, dass wenigstens eine Seite der unbeschichteten Metallfolie ein Verhältnis Q von arithmetischem Mittenrauwert R(1)ₐ zu arithmetischem Mittenrauwert R(2)ₐ im Bereich von 1,70 - 10,00 aufweist.

Für den Fall, dass das Bondsubstrat eine Metallfolie umfassen soll, die einen Grundkörper und eine Beschichtung umfasst, kann gemäß einer zweiten Ausführungsform in Schritt (A) eine Metallfolie bereitgestellt werden, die eine Beschichtung umfasst, und in Schritt (B) die beschichtete Metallfolie so behandelt werden, dass vorzugsweise die beschichtete Seite der Metallfolie ein Verhältnis Q von arithmetischem Mittenrauwert R(1)ₐ zu arithmetischem Mittenrauwert R(2)ₐ im Bereich von 1,70 - 10,00 aufweist.

Für den Fall, dass das Bondsubstrat eine Metallfolie umfassen soll, die einen Grundkörper und eine Beschichtung umfasst, kann gemäß einer dritten Ausführungsform in Schritt (A) eine Metallfolie bereitgestellt werden, die keine Beschichtung umfasst, und in Schritt (B) (i) die unbeschichtete Metallfolie so behandelt werden, dass wenigstens eine Seite der unbeschichteten Metallfolie ein Verhältnis Q von arithmetischem Mittenrauwert R(1)ₐ zu arithmetischem Mittenrauwert R(2)ₐ im Bereich von 1,70 - 10,00 aufweist, und (ii) anschließend auf die wenigstens eine Seite der unbeschichteten Metallfolie, die ein Verhältnis Q von arithmetischem Mittenrauwert R(1)ₐ zu arithmetischem Mittenrauwert R(2)ₐ im Bereich von 1,70 - 10,00 aufweist, eine Beschichtung aufgebracht werden. In diesem Fall werden vorzugweise der arithmetische Mittenrauwert R(1)ₐ und der arithmetische Mittenrauwert R(2)ₐ so bestimmt, wie dies hierin für das Bondsubstrat beschrieben ist. Das Aufbringen der Beschichtung erfolgt vorzugsweise so, dass das Verhältnis Q von arithmetischem Mittenrauwert R(1)ₐ zu arithmetischem Mittenrauwert R(2)ₐ unverändert bleibt, zum Beispiel durch Galvanisierung oder chemische Abscheidung. Bei der Beschichtung handelt es sich vorzugsweise um eine wie hierin an anderer Stelle beschriebene Beschichtung.

Die Behandlung der Metallfolie ist nicht weiter eingeschränkt.

Bei der Behandlung der Metallfolie werden vorzugsweise Vertiefungen auf der Unterseite der Metallfolie eingebracht, um ein Verhältnis Q von arithmetischem Mittenrauwert R(1)ₐ zu arithmetischem Mittenrauwert R(2)ₐ im Bereich von 1,70 - 10,00 einzustellen. Das Eindrücken von Vertiefungen auf der Unterseite der Metallfolie kann prinzipiell auf jede, dem Fachmann bekannte und geeignet erscheinende Art und Weise durchgeführt werden.

Gemäß einer bevorzugten Ausführungsform erfolgt die Behandlung der Metallfolie durch ein Verfahren, das aus der Gruppe ausgewählt ist, die aus Walzen, Bürsten, Prägen, Körnen, Kerben, Stempeln, Senken, Furchen und Ätzen besteht.

Gemäß einer besonders bevorzugten Ausführungsform erfolgt die Behandlung der Metallfolie durch Walzen.

Unter Walzen wird vorzugsweise ein Bearbeitungsverfahren verstanden, bei dem ein Werkstoff, hier die Metallfolie, zwischen zwei oder mehreren rotierenden Werkzeugen bearbeitet wird. Dabei wird durch das Walzen in die Metallfolie vorzugsweise ein Relief übertragen. Das Walzen kann sowohl als Warmwalzen als auch Kaltwalzen durchgeführt werden. Bevorzugt erfolgt das Walzen als Kaltwalzen.

Gemäß einer bevorzugten Ausführungsform erfolgt das Walzen durch wenigstens eine Walze.

Unter einer Walze wird vorzugsweise ein im Wesentlichen zylindrischer Körper verstanden. Die Walze kann grundsätzlich jeden beliebigen Durchmesser haben. Für den vorgesehenen Einsatzzweck eignen sich bevorzugt Walzen mit einem Durchmesser im Bereich von 50 - 150 mm. Ferner sollte die Walze aus einem Material gebildet sein, das unter Einsatzbedingungen härter ist als das Material der Metallfolie. Geeignete Walzen können daher zum Beispiel aus geschmiedetem Stahl, Hartmetall oder Stahlguss gebildet sein.

Gemäß einer bevorzugten Ausführungsform erfolgt das Walzen mit einer Anordnung, die wenigstens eine Walze umfasst. Es sind auch Anordnungen mit mehreren Walzen, zum Beispiel zwei oder mehr Walzen, möglich. Geeignet ist zum Beispiel eine Anordnung, bei der wenigstens zwei Walzen gegenläufig rotieren und die Metallfolie zwischen den zwei gegenläufigen Walzen durchgeführt wird. Die zwei gegenläufigen Walzen sind so angeordnet, dass zwischen den beiden Walzen ein Abstand vorgesehen ist. Dieser Abstand entspricht vorzugsweise der Dicke des Bondsubstrats.

Die Geometrie der Walze ist nicht weiter eingeschränkt. Das Walzen erfolgt vorzugsweise mit wenigstens einer Walze, die eine zylindrische Oberfläche aufweist. Die zylindrische Oberfläche der Walze weist vorzugsweise ein Relief auf.

Das Relief wird vorzugsweise durch Struktureinheiten gebildet. Die Struktureinheiten ergeben vorzugsweise ein Muster. Das Muster der zylindrischen Oberfläche der Walze wird beim Durchlaufen der Metallfolie durch die Anordnung in die Metallfolie eingebracht.

Das Muster ist vorzugsweise durch eine alternierende Abfolge von Erhebungen entlang der Walzenachse oder senkrecht zur Walzenachse gekennzeichnet. Die Abstände zwischen den Erhebungen können entsprechend dem gewünschten Verhältnis Q von arithmetischem Mittenrauwert R(1)ₐ zu arithmetischem Mittenrauwert R(2)ₐ angepasst werden.

Das Muster ist ferner vorzugsweise durch Höhenunterschiede der zylindrischen Oberfläche der Walze gekennzeichnet. Der Höhenunterschied kann ebenfalls entsprechend dem gewünschten Verhältnis Q von arithmetischem Mittenrauwert R(1)ₐ zu arithmetischem Mittenrauwert R(2)ₐ eingestellt werden. Der Höhenunterschied der zylindrischen Oberfläche der Walze kann zum Beispiel im Bereich von 2 - 10 µm liegen. Dabei hängt die Tiefe der in die Metallfolie eingebrachten Vertiefungen von der Eindringtiefe des Reliefs der wenigstens einen Walze in die Metallfolie ab. Es ist möglich, dass der Höhenunterschied des Reliefs größer ist als die in die Metallfolie eingebrachten Vertiefungen. Das Umformen der Metallfolie mit Walzen, wobei wenigstens eine erste Walze ein Relief aufweist, das beim Umformen auf die Metallfolie übertragen wird, wird auch als Prägewalzen bezeichnet.

Gemäß einer weiteren Ausführungsform erfolgt die Behandlung der Metallfolie durch Stempeln. Ein Stempel ist eine mit einem Relief versehene Oberfläche. Das Relief weist einen Höhenunterschied auf. Für einen Stempel eignen sich prinzipiell alle dem Fachmann bekannten und geeignet erscheinenden Materialien, insbesondere jedoch dieselben wie für die Walzen. Beim Stempeln wird ein Stempel auf die Metallfolie abgesenkt. Dabei wird das Relief soweit in die Metallfolie gedrückt, bis das gewünschte Verhältnis Q von arithmetischem Mittenrauwert R(1)ₐ zu arithmetischem Mittenrauwert R(2)ₐ erreicht ist. Vorzugsweise ist beim Stempeln der Metallfolie auf der dem Stempel abgewandten Seite der Metallfolie ein weiteres Werkzeug oder eine Platte vorgesehen, die so ausgebildet ist, dass die umzuformende Metallfolie nicht etwa durch ein sich Verbiegen dem Stempel ausweichen kann. Vielmehr wird die umzuformende Metallfolie durch das weitere Werkzeug in Bezug auf die Stempelrichtung in Position gehalten.

In Schritt (B) wird somit ein Bondsubstrat erhalten, das eine Oberseite und eine Unterseite umfasst, wobei die Unterseite des Bondsubstrats (i) einen arithmetischen Mittenrauwert R(1)ₐ entlang wenigstens einer Strecke S1 aufweist, und (ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft, wobei das Verhältnis Q von arithmetischem Mittenrauwert R(1)ₐ zu arithmetischem Mittenrauwert R(2)ₐ im Bereich von 1,70 - 10,00 liegt.

Das in Schritt (B) erhaltene Bondsubstrat kann eine Metallfolie umfassen. Das Bondsubstrat kann dabei eine Metallfolie sein. Gemäß einer bevorzugten Ausführungsform umfasst das Bondsubstrat vorzugsweise eine Metallfolie, die einen Grundkörper umfasst, auf dem eine Beschichtung angeordnet sein kann, wobei die Unterseite des Bondsubstrats (i) durch den Grundkörper geschaffen ist, wenn auf dem Grundkörper keine Beschichtung angeordnet ist, und (ii) durch die Beschichtung geschaffen ist, wenn auf dem Grundkörper eine Beschichtung angeordnet ist.

In Schritt (C) des Verfahrens wird ein Kontaktierungsmittel bereitgestellt.

Bei dem Kontaktierungsmittel handelt es vorzugsweise um ein wie hierin an anderer Stelle beschriebenes Kontaktierungsmittel.

In Schritt (D) des Verfahrens erfolgt das Aufbringen des Kontaktierungsmittels auf die Unterseite des Bondsubstrats unter Ausbildung einer Kontaktierungsschicht, wobei die Kontaktierungsschicht mit der Unterseite des Bondsubstrats wenigstens bereichsweise flächig verbunden ist.

Das Aufbringen des Kontaktierungsmaterials auf die Unterseite des Bondsubstrats unter Ausbildung einer Kontaktierungsschicht kann durch fachübliche Verfahren erfolgen. Vorzugsweise erfolgt das Aufbringen des Kontaktierungsmaterials durch Jetten, Dispensen, Sprühen, Pinseln, Tupfen, Tauchen oder Drucken, insbesondere Siebdrucken oder Schablonendrucken.

Gemäß einer bevorzugten Ausführungsform erfolgt in einem weiteren Schritt (E) das Aufbringen eines Vorfixiermittels auf die Kontaktierungsschicht und/oder auf nicht mit der Kontaktierungsschicht versehene Bereiche der Unterseite des Bondsubstrats unter Ausbildung einer Vorfixierschicht, wobei die Vorfixierschicht mit der Kontaktierungsschicht und/oder mit nicht mit der Kontaktierungsschicht versehenen Bereichen des Bondsubstrats verbunden ist. Bei dem Vorfixiermittel handelt es vorzugsweise um ein wie hierin an anderer Stelle beschriebenes Vorfixiermittel. Das Aufbringen des Vorfixiermittels auf die Kontaktierungsschicht kann durch fachübliche Verfahren erfolgen. Vorzugsweise erfolgt das Aufbringen des Vorfixiermittels durch Jetten, Dispensen, Sprühen, Pinseln, Tupfen, Tauchen oder Drucken, insbesondere Siebdrucken oder Schablonendrucken.

Gemäß einer bevorzugten Ausführungsform erfolgt in einem weiteren Schritt (F) des Verfahrens eine Vortrocknung. Die Vortrocknung kann dazu dienen, in dem Kontaktierungsmaterial und falls vorhanden in dem Vorfixiermittel enthaltene flüchtige Bestandteile, wie zum Beispiel organische Verbindung, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen. Die Vortrocknung hat üblicherweise einen Volumenschwund zur Folge, so dass auch die Dicke der Kontaktierungsschicht und falls vorhanden der Vorfixierschicht reduziert wird.

Bei dem Verfahren wird eine Substratanordnung erhalten, mit der das Bondsubstrat mit der Oberseite eines Elektronikbauteils über die Kontaktierungsschicht besonders stabil stoffschlüssig verbunden werden kann.

Die Erfindung stellt ein Verfahren zur Herstellung einer elektronischen Baugruppe bereit.

Das Verfahren umfasst die folgenden Schritte:
(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist,
(C) Bereitstellung einer Substratanordnung,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.

In Schritt (A) des Verfahrens wird ein Grundsubstrat bereitgestellt. Das Grundsubstrat umfasst eine Metallschicht. Ferner weist das Grundsubstrat eine Oberseite auf.

Die Metallschicht des Grundsubstrats kann zum Beispiel Kupfer umfassen. Vorzugsweise kann die Metallschicht des Grundsubstrats aus einer Metallfolie gebildet sein. Gemäß einer bevorzugten Ausführung umfasst die Metallschicht des Grundsubstrats eine Kupferfolie.

Gemäß einer bevorzugten Ausführungsform besteht das Grundsubstrat aus der Metallschicht.

Gemäß einer anderen bevorzugten Ausführungsform umfasst das Grundsubstrat eine Metallschicht und eine Schicht aus isolierendem Material. Gemäß einer weiteren bevorzugten Ausführungsform umfasst das Grundsubstrat eine Metallschicht und eine Schicht aus isolierendem Material, die stoffschlüssig miteinander verbunden sind. Vorzugsweise umfasst das Grundsubstrat eine Schicht aus isolierendem Material, die auf einer ersten Seite und einer der ersten Seite abgewandten zweiten Seite stoffschlüssig mit einer Metallschicht verbunden ist.

Das isolierende Material des Grundsubstrats ist vorzugsweise aus der Gruppe ausgewählt, die aus Glas und Keramik besteht. Die Keramik kann zum Beispiel aus der Gruppe ausgewählt sein, die aus Oxidkeramiken, Nitridkeramiken und Carbidkeramiken besteht.

Gemäß einer bevorzugten Ausführungsform ist das Grundsubstrat aus der Gruppe ausgewählt, die aus Metall-Keramik-Substraten, Printed Circuit Boards (PCBs) und Leadframes besteht. Gemäß einer besonders bevorzugten Ausführungsform handelt es sich bei dem Grundsubstrat um ein fachübliches Metall-Keramik-Substrat. Das Metall-Keramik-Substrat ist vorzugsweise aus der Gruppe ausgewählt, die aus DCB (Direct Copper Bonded)-Substraten und AMB (Active Metal Brazed)-Substraten besteht.

Die Oberseite des Grundsubstrats wird vorzugsweise durch die Metallschicht geschaffen.

In Schritt (B) des Verfahrens wird ein Elektronikbauteil bereitgestellt. Das Elektronikbauteil weist eine Oberseite und eine Unterseite auf.

Bei dem Elektronikbauteil handelt es vorzugsweise um ein wie hierin an anderer Stelle beschriebenes Elektronikbauteil.

In Schritt (C) des Verfahrens wird eine Substratanordnung bereitgestellt.

Bei der Substratanordnung handelt es sich vorzugsweise um eine wie hierin an anderer Stelle beschriebene Substratanordnung.

Die Substratanordnung weist daher vorzugsweise auf
(a) ein Bondsubstrat, das eine Oberseite und eine Unterseite umfasst, und
(b) eine Kontaktierungsschicht, die ein Kontaktierungsmittel umfasst, wobei die Kontaktierungsschicht mit der Unterseite des Bondsubstrats wenigstens bereichsweise flächig verbunden ist,
wobei die Unterseite des Bondsubstrats
(i) einen arithmetischen Mittenrauwert R(1)ₐ entlang wenigstens einer Strecke S1 aufweist, und
(ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft,
wobei das Verhältnis Q von arithmetischem Mittenrauwert R(1)ₐ zu arithmetischem Mittenrauwert R(2)ₐ im Bereich von 1,70 - 10,00 liegt.

In Schritt (D) des Verfahrens wird die Oberseite des Grundsubstrats mit der Unterseite des Elektronikbauteils unter Ausbildung einer stoffschlüssigen Verbindung kontaktiert.

Das Grundsubstrat und das Elektronikbauteil werden hierzu vorzugsweise so positioniert, dass die Unterseite des Elektronikbauteils mit der Oberseite des Grundsubstrats vorzugsweise über ein Kontaktierungsmaterial in Kontakt steht. Bei dem Kontaktierungsmittel kann es sich beispielsweise um ein Kontaktierungsmittel handeln, wie es hierin an anderer Stelle in Bezug auf die Substratanordnung beschrieben ist. Folglich kann es sich bei dem Kontaktierungsmaterial zum Beispiel um eine Sinterpaste, eine Lotpaste oder einen Leitkleber handeln. Der Aufbau umfassend das Grundsubstrat und das Elektronikbauteil wird anschließend einer Behandlung unterzogen, die eine stoffschlüssige Verbindung durch das Kontaktierungsmaterial erlaubt. Dabei wird die Unterseite des Elektronikbauteils auf der Oberseite des Grundsubstrats befestigt.

In Schritt (E) des Verfahrens wird die Oberseite des Elektronikbauteils mit der Kontaktierungsschicht der Substratanordnung unter Ausbildung einer stoffschlüssigen Verbindung kontaktiert. Dabei erfolgt vorzugsweise die Ausbildung einer stoffschlüssigen Verbindung zwischen der Oberseite des Elektronikbauteils und dem Bondsubstrat.

Die Substratanordnung und das Elektronikbauteil werden hierzu vorzugsweise so positioniert, dass die Kontaktierungsschicht der Substratanordnung mit der Oberseite des Elektronikbauteils in Kontakt steht. Der Aufbau umfassend die Substratanordnung und das Elektronikbauteil wird anschließend einer Behandlung unterzogen, die eine stoffschlüssige Verbindung durch das Kontaktierungsmaterial der Kontaktierungsschicht erlaubt. Dabei wird das Bondsubstrat der Substratanordnung auf der Oberseite des Elektronikbauteils befestigt.

Die Schritte (D) und (E) können in einem Fertigungsschritt oder in unterschiedlichen Fertigungsschritten durchgeführt werden. Dabei können die Schritte (D) und (E) sequenziell oder gleichzeitig durchgeführt werden.

Sofern die Schritte (D) und (E) sequenziell durchgeführt werden, kann Schritt (D) zeitlich vor Schritt (E) erfolgen. Andererseits ist es auch möglich, dass Schritt (E) vor Schritt (D) erfolgt.

Sofern die Schritte (D) und (E) sequenziell durchgeführt werden, kann gemäß einer ersten Ausführungsform in Schritt (D) das Elektronikbauteil Teil einer ersten Anordnung sein, die das Elektronikbauteil und das Bondsubstrat umfasst. In diesem Fall kann zunächst in Schritt (E) eine erste Anordnung, die das Elektronikbauteil und das Bondsubstrat umfasst, hergestellt werden, indem die Oberseite des Elektronikbauteils mit der Kontaktierungsschicht der Substratanordnung unter Ausbildung einer stoffschlüssigen Verbindung zwischen der Oberseite des Elektronikbauteils und dem Bondsubstrat kontaktiert wird. Diese erste Anordnung kann anschließend in Schritt (D) mit dem Grundsubstrat kontaktiert werden, so dass die Unterseite des Elektronikbauteils als Teil der ersten Anordnung mit der Oberseite des Grundsubstrats stoffschlüssig verbunden wird.

Sofern die Schritte (D) und (E) sequenziell durchgeführt werden, kann gemäß einer zweiten Ausführungsform in Schritt (E) das Elektronikbauteil Teil einer zweiten Anordnung sein, die das Grundsubstrat und das Elektronikbauteil umfasst. In diesem Fall kann zunächst in Schritt (D) eine zweite Anordnung, die das Grundsubstrat und das Elektronikbauteil umfasst, hergestellt werden. Diese zweite Anordnung kann anschließend in Schritt (E) mit der Substratanordnung kontaktiert werden, so dass die Unterseite des Bondsubstrats mit der Oberseite des Elektronikbauteils als Teil der zweiten Anordnung stoffschlüssig verbunden wird.

Durch die stoffschlüssige Verbindung von Grundsubstrat, Elektronikbauteil und Bondsubstrat wird eine elektronische Baugruppe erhalten.

Gemäß einer bevorzugten Ausführungsform erfolgt in einem weiteren Schritt (F) die elektrische Kontaktierung eines Bereichs auf der Oberseite des Bondsubstrats mit einem Bereich auf der Oberseite des Grundsubstrats. Die elektrische Kontaktierung erfolgt vorzugsweise durch Drahtbonden. Für das Drahtbonden wird vorzugsweise ein Bonddraht verwendet. Der Bonddraht umfasst vorzugsweise Kupfer. Gemäß einer bevorzugten Ausführungsform ist der Bonddraht aus einem Material beschaffen, das aus der Gruppe ausgewählt ist, die aus Kupfer und Kupferlegierungen besteht.

### Methodenbeschreibung:

Zur Bestimmung des Mittenrauwerts R(1)ₐ und des Mittenrauwerts R(2)ₐ wurden unter Verwendung des Konfokalmikroskops µsurf custom (NanoFocus AG, Deutschland) an der Unterseite des Bondsubstrats 3D-Aufnahmen der Oberfläche angefertigt, die die jeweiligen Bezugsstrecken S1 und S2 umfassten. Mittels der Software µSoft Analysis Premium (7.4.8872; NanoFocus AG, Deutschland) wurden die mikroskopischen 3D-Aufnahmen ausgewertet. Hierzu wurde zunächst eine eventuelle Durchbiegung des Bondsubstrats in den 3D-Aufnahmen korrigiert (Verwendung eines Polynoms von Grad 2). Danach wurden die Bezugsstrecken S1 und S2 (zum Beispiel mit einer Breite von 0,0315 mm) definiert und das Rauheitsprofil entlang der Bezugsstrecken S1 und S2 unter Verwendung eines Gauß-Filters (0,8 mm) erhalten. Es wurden jeweils wenigstens zehn parallel zueinander verlaufende Bezugsstrecken S1 gleicher Länge und wenigstens zehn parallel zueinander verlaufende Bezugsstrecken S2 gleicher Länge ausgewählt, wobei die Bezugsstrecken S2 jeweils senkrecht zu den Bezugsstrecken S1 verliefen. Die Bezugsstrecken S1 wiesen dabei eine Länge von wenigstens 20% des Umfangs des Bondsubstrats auf. Die Bezugsstrecken S2 wiesen eine Länge von wenigstens 50% der Länge der Bezugsstrecken S1 auf. Aus den entlang der Bezugsstrecken S1 und S2 erhaltenen Rauheitsprofilen erfolgte die Bestimmung des Mittenrauwerts R(1)ₐ und des Mittenrauwerts R(2)ₐ gemäß der zum Anmeldetag gültigen Version der Norm DIN EN ISO 4287.

### Figurenbeschreibung:

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigen:
Figur 1 die Seitenansicht einer erfindungsgemäßen Substratanordnung;
Figur 2 die Seitenansicht einer erfindungsgemäßen Substratanordnung; und
Figur 3 die Seitenansicht einer elektronischen Baugruppe, die durch das erfindungsgemäße Verfahren erhalten wird.

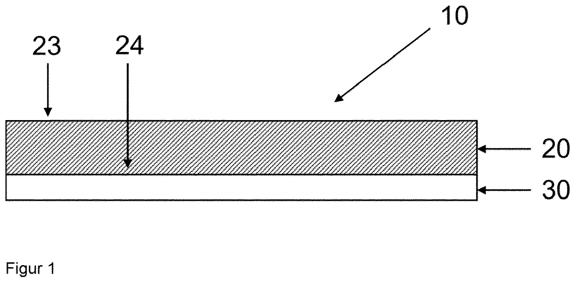

Figur 1 zeigt eine erfindungsgemäße Substratanordnung 10, die ein Bondsubstrat 20 und eine Kontaktierungsschicht 30 umfasst. Das Bondsubstrat 20 weist eine Oberseite 23 und eine Unterseite 24 auf. Die Kontaktierungsschicht 30 ist flächig mit der Unterseite 24 des Bondsubstrats 20 verbunden. Die Unterseite 24 des Bondsubstrats 20 weist auf: (i) einen arithmetischen Mittenrauwert R(1)ₐ entlang wenigstens einer Strecke S1 und (ii) einen arithmetischen Mittenrauwert R(2)ₐ entlang wenigstens einer Strecke S2, wobei die wenigstens eine Strecke S2 senkrecht zur wenigstens einen Strecke S1 verläuft, und wobei das Verhältnis Q von arithmetischem Mittenrauwert R(1)ₐ zu arithmetischem Mittenrauwert R(2)ₐ im Bereich von 1,70 - 10,00 liegt.

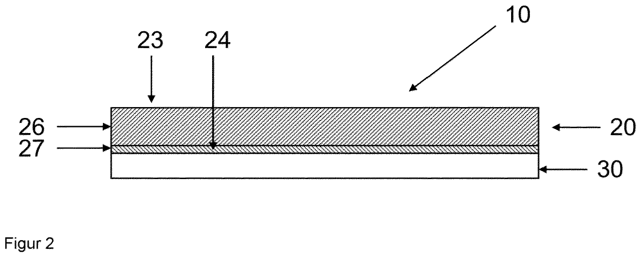

Figur 2 zeigt eine erfindungsgemäße Substratanordnung 10, die ein Bondsubstrat 20 und eine Kontaktierungsschicht 30 umfasst. Das Bondsubstrat 20 umfasst eine Metallfolie, die einen Grundkörper 26 umfasst, auf dem eine Beschichtung 27 angeordnet ist. Die Unterseite 24 des Bondsubstrats 20 wird von der Beschichtung 27 geschaffen und die Oberseite 23 des Bondsubstrats 20 wird vom Grundkörper 26 der Metallfolie geschaffen. Die Unterseite 24 des Bondsubstrats 20 weist auf: (i) einen arithmetischen Mittenrauwert R(1)ₐ entlang wenigstens einer Strecke S1 und (ii) einen arithmetischen Mittenrauwert R(2)ₐ entlang wenigstens einer Strecke S2, wobei die wenigstens eine Strecke S2 senkrecht zur wenigstens einen Strecke S1 verläuft, und wobei das Verhältnis Q von arithmetischem Mittenrauwert R(1)ₐ zu arithmetischem Mittenrauwert R(2)ₐ im Bereich von 1,70 - 10,00 liegt.

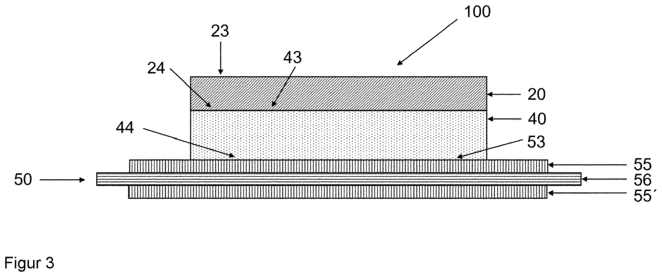

Figur 3 zeigt eine elektronische Baugruppe 100, die durch das erfindungsgemäße Verfahren hergestellt werden kann. Die elektronische Baugruppe 100 umfasst ein Bondsubstrat 20, ein Elektronikbauteil 40 und ein Grundsubstrat 50. Das Grundsubstrat 50 weist eine Schicht aus isolierendem Material 56 auf, die beidseitig mit einer Metallschicht 55, 55' flächig verbunden ist. Bei dem Grundsubstrat 50 handelt es sich typischerweise um ein Metall-Keramik-Substrat. Die Oberseite 53 des Grundsubstrats 50 wird durch die Metallschicht 55 geschaffen. Auf der Oberseite 53 des Grundsubstrats 50 ist ein Elektronikbauteil 40 angeordnet, das eine Oberseite 43 und eine Unterseite 44 aufweist. Die Unterseite 44 des Elektronikbauteils 40 ist auf der Oberseite 53 des Grundsubstrats 50 angeordnet. Das Elektronikbauteil 40 ist mit dem Grundsubstrat 50 flächig verbunden. Hierzu kann das Elektronikbauteil 40 zum Beispiel unter Verwendung einer Sinterpaste auf dem Grundsubstrat 50 befestigt sein. Zwischen der Oberseite 53 des Grundsubstrats 50 und der Unterseite 44 des Elektronikbauteils 40 kann sich daher eine Sinterschicht befinden (nicht gezeigt). Das Elektronikbauteil 40 ist mit einem Bondsubstrat 20 verbunden. Das Bondsubstrat 20 weist eine Oberseite 23 und eine Unterseite 24 auf. Die Unterseite 24 des Bondsubstrats 20 ist auf der Oberseite 43 des Elektronikbauteils 40 angeordnet. Das Bondsubstrat 20 ist auf dem Elektronikbauteil 40 befestigt. Die Befestigung erfolgt, indem zunächst eine Substratanordnung, die das Bondsubstrat 20 und eine Kontaktierungsschicht umfasst, auf der Oberseite 43 des Elektronikbauteils 40 so positioniert wird, dass die Kontaktierungsschicht mit der Oberseite 43 des Elektronikbauteils 40 in Kontakt steht. Anschließend wird der so erhaltene Aufbau Bedingungen ausgesetzt, die die Ausbildung einer stoffschlüssigen Verbindung zwischen dem Bondsubstrat 20 und dem Elektronikbauteil 40 ermöglichen. Die Kontaktierungsschicht kann beispielsweise aus einer vorgetrockneten Sinterpaste bestehen. In diesem Fall wird der Aufbau mit Temperatur und Druck beaufschlagt, um die Ausbildung einer Sinterverbindung zwischen dem Bondsubstrat 20 und dem Elektronikbauteil 40 zu ermöglichen. Die elektronische Baugruppe 100 umfasst dann zwischen dem Bondsubstrat 20 und dem Elektronikbauteil 40 eine Sinterschicht (nicht gezeigt). Die Oberseite 23 des Bondsubstrats 20 kann mit unbestückten Bereichen auf der Oberseite 53 des Grundsubstrats 50 mit einem Bonddraht kontaktiert werden (nicht gezeigt). Die Oberseite 23 des Bondsubstrats 20 kann außerdem mit einer weiteren Komponente, insbesondere unter Verwendung eines Sintermaterials, stoffschlüssig verbunden werden (nicht gezeigt).

### Beispiele:

### Herstellung von Substratanordnungen - Beispiel 1:

Zur Herstellung einer Substratanordnung gemäß Beispiel 1 wurde eine Kupferfolie mit einer Dicke von 50 µm verwendet. Die Kupferfolie wurde gewalzt, so dass die Unterseite der Kupferfolie einen arithmetischen Mittenrauwert R(1)ₐ, einen arithmetischen Mittenrauwert R(2)ₐ und ein Verhältnis Q von arithmetischem Mittenrauwert R(1)ₐ zu arithmetischem Mittenrauwert R(2)ₐ gemäß Tabelle 1 aufwies. Der arithmetische Mittenrauwert R(1)ₐ und der arithmetische Mittenrauwert R(2)ₐ wurden dabei wie vorstehend beschrieben bestimmt. Die Kupferfolie wurde mittels fotolithografischem Ätzen unter Verwendung einer geeigneten Maskierung mit einer Eisenchlorid (FeCl₃)-Ätzlösung in Kupferfolienstücke der Abmaße 4 mm x 8 mm strukturiert, wobei die einzelnen Kupferfolienstücke noch über Stege miteinander verbunden waren. Die Maskierung wurde anschließend entfernt. Dadurch wurden über Stege miteinander verbundene Bondsubstrate erhalten, die jeweils eine Oberseite und eine Unterseite aufwiesen, wobei die Unterseite der Bondsubstrate einen arithmetischen Mittenrauwert R(1)ₐ, einen arithmetischen Mittenrauwert R(2)ₐ und ein Verhältnis Q von arithmetischem Mittenrauwert R(1)ₐ zu arithmetischem Mittenrauwert R(2)ₐ gemäß Tabelle 1 aufwies.

Die Unterseite der Bondsubstrate wurde sodann mit einer Kontaktierungsschicht versehen. Hierzu wurde auf einen Bereich von 3 mm x 3 mm auf der Unterseite der Bondsubstrate eine Sinterpaste (ASP 338-28, Heraeus) mittels Schablonendrucks aufgebracht (Nassschichtdicke von 50 µm). Außer dem mit Sinterpaste versehenen Bereich wies die Unterseite der Bondsubstrate neben einem umlaufenden, von Sinterpaste freien Randbereich von 0,5 mm Breite einen freien Bereich von 4,0 mm × 4,5 mm auf. Die so mit einer Kontaktierungsschicht versehenen Bondsubstrate wurden anschließend an Luftatmosphäre für zehn Minuten bei 100°C getrocknet und unter Trennung der Stege mittels Laser vereinzelt, wobei Substratanordnungen gemäß Beispiel 1 erhalten wurden.

### Herstellung von Substratanordnungen - Beispiele 2 - 7 und Vergleichsbeispiele 1 - 4:

Die Substratanordnungen der Beispiele 2 - 7 und der Vergleichsbeispiele 1 - 4 wurden analog zu der Substratanordnung von Beispiel 1 hergestellt, wobei jedoch der arithmetische Mittenrauwert R(1)ₐ, der arithmetische Mittenrauwert R(2)ₐ und das Verhältnis Q von arithmetischem Mittenrauwert R(1)ₐ zu arithmetischem Mittenrauwert R(2)ₐ gemäß Tabelle 1 variiert wurden. Hierzu wurden zum Teil kommerziell erhältliche Kupferfolien eingesetzt. Zum Teil wurden der arithmetische Mittenrauwert R(1)ₐ, der arithmetische Mittenrauwert R(2)ₐ und das Verhältnis Q von arithmetischem Mittenrauwert R(1)ₐ zu arithmetischem Mittenrauwert R(2)ₐ durch Variation des Walzprozesses (Verwendung von Walzen mit unterschiedlichen Mustern, Abfolgen von Erhebungen auf der Walze und Höhenunterschieden der zylindrischen Oberfläche der Walze) eingestellt, so dass unterschiedliche Profile an der Unterseite der Kupferfolien erhalten wurden.

### Herstellung von elektronischen Baugruppen - Beispiel 1:

Zur Herstellung einer elektronischen Baugruppe wurde zunächst eine Anordnung aus einem Grundsubstrat und einem Elektronikbauteil geschaffen. Als Grundsubstrat wurde ein kommerziell erhältliches direktmetallisiertes Kupfer-Keramik-Substrat (DCB; Condura^{®} classic, Heraeus) und als Elektronikbauteil ein Siliziumchip mit der Abmessung 4 mm x 4 mm (Dicke = 250 µm), der eine unterseitige Metallisierung (100 nm Aluminium, 50 nm Titan, 100 nm Nickel und schließlich 700 nm Silber) sowie eine oberseitige Metallisierung (700 nm Silber) aufwies, verwendet.

Auf die Oberseite des Kupfer-Keramik-Substrats wurde eine Sinterpaste (ASP 338-28, Heraeus) mittels Schablonendrucks aufgebracht (Nassschichtdicke = 100 µm). Das mit Sinterpaste versehene Kupfer-Keramik-Substrat wurde an Luftatmosphäre für zehn Minuten bei 100°C getrocknet und anschließend abgekühlt. Auf der vorgetrockneten Sinterpaste wurde der Siliziumchip positioniert, so dass die Unterseite des Siliziumchips mit der Oberseite des Kupfer-Keramik-Substrats in Kontakt stand.

Anschließend wurden die Substratanordnung gemäß Beispiel 1 auf der Oberseite des Siliziumchips positioniert, so dass die Kontaktierungsschicht der Substratanordnung mit der Oberseite des Siliziumchips in Kontakt stand. Dabei ragte der freie Bereich auf der Unterseite des Bondsubstrats über die Oberseite des Siliziumchips hinaus.

Sodann wurde der erhaltene Aufbau gesintert. Das Sintern erfolgte in einer PINK Sinterpresse (Fa. Pink, Wertheim) für eine Dauer von drei Minuten in einer Stickstoffatmosphäre bei einem Druck von 20 MPa und einer Temperatur von 250°C. Dabei wurde eine elektronische Baugruppe erhalten.

### Herstellung von elektronischen Baugruppen - Beispiele 2 - 7 und Vergleichsbeispiele 1 - 4:

Mit den Substratanordnungen der Beispiele 2 - 7 und der Vergleichsbeispiele 1 - 4 wurden ebenfalls elektronische Baugruppen hergestellt. Dabei wurde analog zur Herstellung der elektronischen Baugruppe mit der Substratanordnung von Beispiel 1 verfahren.

### Test auf Haftfestigkeit:

Die mit den Substratanordnungen der Beispiele 1 - 7 und der Vergleichsbeispiele 1 - 4 hergestellten elektronischen Baugruppen wurden in Bezug auf die Haftfestigkeit der Bondsubstrate auf der Oberseite der Siliziumchips untersucht. Mittels einer Materialprüfmaschine von ZwickRoell (500 N, ZwickRoell GmbH & Co KG) wurde die Kraft gemessen, die aufgebracht werden musste, um die mit der Oberseite der Siliziumchips stoffschlüssig verbundenen Bondsubstrate von der Oberseite der Siliziumchips abzuziehen. Hierzu wurden die mit den Substratanordnungen der Beispiele 1 - 7 und der Vergleichsbeispiele 1 - 4 hergestellten elektronischen Baugruppen in einen Niederhalter eingespannt, die über die Oberseite der Siliziumchips hinausragenden freien Bereiche auf der Unterseite der Bondsubstrate in einer Schraubenspannvorrichtung fixiert und in einem Abzugswinkel von 90° mit einer Geschwindigkeit von 50 mm/min abgezogen. Die Haftfestigkeit wurde anschließend auf einer Skala von ++ (sehr hohe Haftfestigkeit) bis - (sehr geringe Haftfestigkeit bewertet). Die Ergebnisse sind in Tabelle 1 dargestellt.

**Tabelle 1: Analyse der Beispiele 1 - 7 und Vergleichsbeispiele 1 - 4.**

| | R(1)ₐ (in µm) | R(2)ₐ (in µm) | Q (R(1)ₐ / R(2)ₐ) | Haftfestigkeit |
|---|---|---|---|---|
| Beispiele | | | | |
| 1 | 0,53 | 0,12 | 4,42 | ++ |
| 2 | 0,33 | 0,14 | 2,36 | + |
| 3 | 0,32 | 0,11 | 2,91 | + |
| 4 | 0,52 | 0,30 | 1,73 | + |
| 5 | 0,42 | 0,14 | 3,00 | + |
| 6 | 0,65 | 0,13 | 5,00 | ++ |
| 7 | 0,54 | 0,25 | 2,16 | + |

| Vergleichsbeispiele | | | | |
|---|---|---|---|---|
| 1 | 0,16 | 0,11 | 1,45 | - |
| 2 | 0,11 | 0,07 | 1,57 | - |
| 3 | 0,15 | 0,09 | 1,67 | - |
| 4 | 2,36 | 0,21 | 11,24 | - |

Die Ergebnisse zeigen, dass mit den erfindungsgemäßen Substratanordnungen der Beispiele 1 - 7 eine besonders stabile stoffschlüssige Verbindung zwischen dem Bondsubstrat und der Oberseite eines Elektronikbauteils über eine Kontaktierungsschicht erreicht werden kann. Die stoffschlüssige Verbindung ist dabei stabiler verglichen mit einer stoffschlüssigen Verbindung, die mit den Substratanordnungen der Vergleichsbeispiele 1 - 4 erhalten wird.

### Bezugszeichenliste:

- 10: Substratanordnung
- 20: Bondsubstrat
- 23: Oberseite (Bondsubstrat)
- 24: Unterseite (Bondsubstrat)
- 26: Grundkörper
- 27: Beschichtung
- 30: Kontaktierungsschicht
- 40: Elektronikbauteil
- 43: Oberseite (Elektronikbauteil)
- 44: Unterseite (Elektronikbauteil)
- 50: Grundsubstrat
- 53: Oberseite (Grundsubstrat)
- 55, 55': Metallschicht
- 56: Schicht aus isolierendem Material
- 100: Elektronische Baugruppe

## Patentansprüche

1. Substratanordnung aufweisend
(a) ein Bondsubstrat, das eine Oberseite und eine Unterseite umfasst, und
(b) eine Kontaktierungsschicht, die ein Kontaktierungsmittel umfasst, wobei die Kontaktierungsschicht mit der Unterseite des Bondsubstrats wenigstens bereichsweise flächig verbunden ist,
**dadurch gekennzeichnet, dass** die Unterseite des Bondsubstrats
(i) einen arithmetischen Mittenrauwert R(1)ₐ entlang wenigstens einer Strecke S1 aufweist, und
(ii) einen arithmetischen Mittenrauwert R(2)ₐ entlang wenigstens einer Strecke S2 aufweist, wobei die wenigstens eine Strecke S2 senkrecht zur wenigstens einen Strecke S1 verläuft,
wobei das Verhältnis Q von arithmetischem Mittenrauwert R(1)ₐ zu arithmetischem Mittenrauwert R(2)ₐ im Bereich von 1,70 - 10,00 liegt.

2. Substratanordnung nach Anspruch 1, **dadurch gekennzeichnet, dass** die Unterseite des Bondsubstrats ein Profil mit sich wiederholenden Struktureinheiten entlang einer ersten Richtung umfasst, wobei sich die wenigstens eine Strecke S1 in die erste Richtung erstreckt.

3. Substratanordnung nach Anspruch 1 oder 2, **dadurch gekennzeichnet, dass** die Unterseite des Bondsubstrats ein Walzprofil entlang einer Walzrichtung umfasst, wobei sich die wenigstens eine Strecke S2 in Walzrichtung erstreckt.

4. Substratanordnung nach einem der vorangegangenen Ansprüche, **dadurch gekennzeichnet, dass** das Bondsubstrat eine Metallfolie umfasst.

5. Substratanordnung nach Anspruch 4, **dadurch gekennzeichnet, dass** die Metallfolie Kupfer umfasst.

6. Substratanordnung nach Anspruch 4 oder 5, **dadurch gekennzeichnet, dass** die Metallfolie einen Grundkörper und eine Beschichtung umfasst.

7. Substratanordnung nach Anspruch 6, **dadurch gekennzeichnet, dass** die Unterseite des Bondsubstrats von der Beschichtung geschaffen wird.

8. Substratanordnung nach Anspruch 6 oder 7, **dadurch gekennzeichnet, dass** die Beschichtung ein Edelmetall umfasst.

9. Substratanordnung nach einem der vorangegangenen Ansprüche, **dadurch gekennzeichnet, dass** das Kontaktierungsmittel ein Sintermaterial umfasst.

10. Substratanordnung nach Anspruch 9, **dadurch gekennzeichnet, dass** das Sintermaterial wenigstens ein Element umfasst, das aus der Gruppe ausgewählt ist, die aus Silber und Kupfer besteht.

11. Substratanordnung nach Anspruch 9 oder 10, **dadurch gekennzeichnet, dass** das Sintermaterial eine Sinterpaste umfasst.

12. Substratanordnung nach Anspruch 11, **dadurch gekennzeichnet, dass** die Sinterpaste vorgetrocknet ist.

13. Substratanordnung nach einem der vorangegangenen Ansprüche, **dadurch gekennzeichnet, dass** das Verhältnis Q von arithmetischem Mittenrauwert R(1)ₐ zu arithmetischem Mittenrauwert R(2)ₐ im Bereich von 1,70 - 8,00 liegt.

14. Substratanordnung nach einem der vorangegangenen Ansprüche, **dadurch gekennzeichnet, dass** die Substratanordnung zur Verbindung mit wenigstens einem Elektronikbauteil ausgestaltet ist.

15. Verfahren zur Herstellung einer elektronischen Baugruppe umfassend die Schritte
(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist, und
(C) Bereitstellung einer Substratanordnung gemäß einem der vorangegangenen Ansprüche,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.
